# EUROPEAN PATENT APPLICATION

(11) **EP 2 477 236 A1**
(43) Date of publication of application: **18.07.2012**
(21) Application number: 10813842.1
(22) Date of filing: 07.09.2010
(51) Int. Cl.: H01L 33/12, H01L 21/205, H01L 33/06, H01L 33/32

(54) **NITRIDE SEMICONDUCTOR MULTILAYER STRUCTURE, METHOD FOR PRODUCING SAME, AND NITRIDE SEMICONDUCTOR LIGHT-EMITTING ELEMENT**

(30) Priority: 07.09.2009 JP 2009206082
(71) Applicant: Panasonic Corporation, Kadoma-shi Osaka 571-8501 (JP)
(72) Inventor: TAKANO, Takayoshi, Kadoma-shi Osaka 571-8686 (JP); TSUBAKI, Kenji, Osaka-shi, Osaka 540-6207 (JP); HIRAYAMA, Hideki, Wako-shi Saitama 351-0198 (JP); FUJIKAWA, Sachie, Wako-shi Saitama 351-0198 (JP)
(74) Representative: Appelt, Christian W.
(86) International application number: PCT/JP2010/065319
(87) International publication number: WO 2011/027896

(57) **Abstract**

The present invention provides a high-quality nitride semiconductor multilayer structure formed of a nitride semiconductor that contains Al as a constituent element; a production method of the nitride semiconductor multilayer structure; and a nitride semiconductor light-emitting element having, as a buffer layer, a high-quality nitride semiconductor multilayer structure formed of a nitride semiconductor that contains Al as a constituent element. The nitride semiconductor light-emitting element of the invention has a stacked structure of a buffer layer **2**, an n-type nitride semiconductor layer **3**, a light-emitting layer **4**, and a p-type nitride semiconductor layer **5**, on one surface side of a single crystal substrate **1** formed of a sapphire substrate. A nitride semiconductor multilayer structure that constitutes the buffer layer **2** includes: a plurality of island-like nuclei **2a** that are formed of AlN, and are formed on the one surface of the single crystal substrate **1**; a first nitride semiconductor layer **2b** that is formed of an AlN layer, and is formed on the one surface side of the single crystal substrate **1** so as to fill gaps between adjacent nuclei **2a** and to cover all the nuclei **2a**; and a second nitride semiconductor layer **2c** that is formed of an AlN layer, and is formed on the first nitride semiconductor layer **2b**. The nitride semiconductor multilayer structure is characterized in that the density of the nuclei **2a** is less than 6×10⁹ nuclei cm⁻².

## Description

### TECHNICAL FIELD

The present invention relates to a nitride semiconductor multilayer structure containing Al as a constituent element, to a method for producing the nitride semiconductor multilayer structure, and to a nitride semiconductor light-emitting element.

### BACKGROUND ART

Nitride semiconductor light-emitting element that emits light in a wavelength region of visible to ultraviolet holds potential of application in a wide range of fields, such as in health, medicine, industry, illumination, precision machinery and the like, because of the advantageous in terms of its low power consumption and small size. Nitride semiconductor light-emitting element for partial wavelength regions, for instance blue light wavelength region, is already in commercial use.

However, as to the nitride semiconductor light-emitting element, not limited to the nitride semiconductor light-emitting element that emits blue light (hereafter, referred to as "blue light-emitting diode"), it is desired for enhanced emission efficiency and light output. In particular, at present, the practical use of a nitride semiconductor light-emitting element that emits light in ultraviolet wavelength region (hereafter, referred to as "ultraviolet light-emitting diode") is hampered by the problem of its considerably poorer external quantum efficiency and light output as compared with the blue light-emitting diode. The low efficiency of light-emitting layer (hereafter, referred to as "internal quantum efficiency") is one of the causes underlying the significantly poor external quantum efficiency and light output.

The internal quantum efficiency of the light-emitting layer formed of nitride semiconductor crystal is influenced by threading dislocations. In a case of high dislocation density of the threading dislocation, non-radiative recombination is dominant, thereby it causes a significant drop in the internal quantum efficiency.

The abovementioned threading dislocations may occur readily, in particular at growth interfaces, in a case where a substrate made of a material such as sapphire or the like, exhibiting a significant lattice mismatch with respect to a nitride semiconductor, is used as a single crystal substrate for epitaxial growth. Therefore, controlling the behavior of each of the constituent elements in the early stages of growth is extremely important in order to obtain a nitride semiconductor crystal having low threading dislocation density. In particular, growth techniques are less established for nitride semiconductor crystal containing Al (particularly AlN) than for nitride semiconductor crystal that does not contain Al (particularly GaN). Therefore, threading dislocations are present in a relatively higher density in the nitride semiconductor crystals containing Al. In the production of an ultraviolet light-emitting diode that needs to include Al among the constituent elements in the nitride semiconductor crystal, therefore, more threading dislocations occur in the nitride semiconductor crystal than in the case of a blue light-emitting diode that is formed of a nitride semiconductor crystal mainly composed of GaN. Thus, the ultraviolet light-emitting diode has lower emission efficiency compared with the blue light-emitting diode.

In order to increase the emission efficiency of an ultraviolet light-emitting diode that is provided with a light-emitting layer that emits light at room temperature in a deep ultraviolet region of wavelength in the range of 230 nm to 350 nm, and with a view to improving the quality of a buffer layer that is formed on one surface side of a single crystal substrate of a sapphire substrate, it has been proposed to use a following configuration (Patent Document 1). In the configuration, the abovementioned buffer layer, which is formed by low-pressure MOVPE, is formed of a nitride semiconductor multilayer structure having: a plurality of island-like nuclei; a first nitride semiconductor layer; and a second nitride semiconductor layer. Here, the plurality of island-like nuclei (hereafter referred to as "AlN nuclei") are formed of AlN, and are formed on the abovementioned one surface of the single crystal substrate. The first nitride semiconductor layer is formed of an AlN layer (pulse supply AlN layer), by intermittently (in pulse) supplying NH₃ which is a group V raw material while continuously supplying TMA1 which is a group III raw material, and is formed on the abovementioned one surface side of the single crystal substrate so as to fill gaps between the AlN nuclei and to cover the AlN nuclei. The second nitride semiconductor layer is formed of an AlN layer (continuous growth AlN layer), by continuous and simultaneous supply of both TMA1 and NH₃, and is formed on the first nitride semiconductor layer.

### PRIOR ART DOCUMENT

### PATENT DOCUMENT

Patent Document 1: JP 2009-54780 A

### SUMMARY OF THE INVENTION

### PROBLEMS TO BE SOLVED BY THE INVENTION

In the ultraviolet light-emitting diode provided with the nitride semiconductor multilayer structure disclosed in Patent Document 1 as a buffer layer, emission efficiency can be enhanced through the reduction of threading dislocation density. Patent Document 1, however, did not specifically disclose the density of AlN nuclei (nuclei density), on the abovementioned one surface of the single crystal substrate, for obtaining a high-quality nitride semiconductor multilayer structure. With regard to the nuclei density, as a result of diligent research, the inventors have found that some of the AlN nuclei densities on the abovementioned one surface of the single crystal substrate make increase the threading dislocation density in the nitride semiconductor multilayer structure and the light-emitting layer, thereby the effect of enhancing emission efficiency was hard to elicit.

In the light of the above-described issues, it is an object of the present invention to provide a high-quality nitride semiconductor multilayer structure formed of a nitride semiconductor that contains Al as a constituent element, to provide a method for producing the nitride semiconductor multilayer structure, and to provide a nitride semiconductor light-emitting element having, as a buffer layer, a high-quality nitride semiconductor multilayer structure formed of a nitride semiconductor that contains A1 as a constituent element.

### MEANS FOR SOLVING THE PROBLEMS

The invention of claim 1 is characterized by comprising a plurality of island-like nuclei that are formed of a nitride semiconductor containing Al as a constituent element, and are formed on one surface of a single crystal substrate; a first nitride semiconductor layer containing Al as a constituent element and formed on said one surface side of the single crystal substrate so as to fill gaps between adjacent nuclei and to cover all the nuclei; and a second nitride semiconductor layer containing A1 as a constituent element and formed on the first nitride semiconductor layer, wherein the density of the nuclei is less than 6×10⁹ cm⁻².

The invention allows obtaining a high-quality nitride semiconductor multilayer structure that is formed of a nitride semiconductor containing A1 as a constituent element. Herein, the size of the plurality of island-like nuclei that are formed on the abovementioned one surface of the single crystal substrate becomes greater along with the progress of the growth of the nuclei. When adjacent nuclei are bonded to one another, threading dislocations occur readily at their bonding interfaces. However, in the invention, the bonding interfaces can be reduced because the density of the nuclei is set not to exceed 6×10⁹ cm⁻². As a result, this allows reducing the threading dislocations that occur upon bonding of adjacent nuclei to one another, and allows obtaining a high-quality nitride semiconductor multilayer structure having few threading dislocations.

In the invention of claim 2, the density of the nuclei is equal to or more than 1×10⁶ cm⁻². By virtue of a nuclei density that is not smaller than 1×10⁶ cm⁻², the first nitride semiconductor layer for filling gaps between nuclei and covering all the nuclei can be formed in a small film thickness. Accordingly, setting the nuclei density to be not smaller than 1×10⁶ cm⁻² allows preventing the formation of cracks, which occurs when the film thickness becomes excessive, and allows easily obtaining the film which fills the nuclei and is a flat shape.

In the invention of claim 3, the density of the nuclei is equal to or more than 1×10⁸ cm⁻². When the nuclei density lies within this range, the distance between adjacent nuclei is of about 1 µm. Therefore, a planar film can be obtained easily that, nevertheless, has low dislocation density. Accordingly, a high-quality light-emitting layer can be formed that has a good interface with few non-radiative recombination centers derived from dislocations.

The invention of claim 4 is the invention according to any one of claims 1 to 3, wherein the nuclei have faces that are tilted with respect to the abovementioned one surface of the single crystal substrate.

In the present invention, the nucleus has faces that are tilted with respect to the abovementioned one surface of the single crystal substrate. Therefore, during formation of the first nitride semiconductor layer, growth in the normal direction to the abovementioned one surface of the single crystal substrate can be suppressed, such that growth in the lateral direction along the abovementioned one surface is progressed readily. Threading dislocations are likely to track along the growth direction of the semiconductor layer, and hence the threading dislocations do not extend readily in the normal direction of the abovementioned one surface of the single crystal substrate, and bend in a direction parallel to the abovementioned one surface, as similar with the direction of the growth of the first nitride semiconductor layer. Accordingly, threading dislocations are eliminated readily through formation of loops with nearby threading dislocations. As a result, it becomes possible to reduce the density of threading dislocations at the surface of the second nitride semiconductor layer.

The invention of claim 5 is the invention according to claims 1 to 4, wherein the nitride semiconductor that constitutes the nuclei is AlN. The invention of claim 6 is the invention according to claim 5, wherein the first nitride semiconductor layer and the second nitride semiconductor layer are formed of AlN.

In this invention, the constituent elements of the nitride semiconductor that constitutes the nuclei are few in number, and hence formation of the nuclei can be controlled more easily. Herein, AlN is a material having large band-gap energy, namely 6.2 eV. Therefore, in a case where there is forming a light-emitting layer, which emits ultraviolet light, on the upper surface side of the second nitride semiconductor layer to produce a nitride semiconductor light-emitting element (ultraviolet light-emitting diode), it becomes possible to prevent the nuclei from absorbing ultraviolet light that is irradiated by the light-emitting layer, and to enhance the external quantum efficiency of the nitride semiconductor light-emitting element.

The invention of claim 7 is the invention according to any one of claims 1 to 6, wherein the single crystal substrate is a sapphire substrate, and the abovementioned one surface has an off-angle, with respect to the c-plane, ranging from 0° to 0.2°.

Through prescribing off-angle in the above range, the present invention allows preventing the nuclei density from exceeding 6×10⁹ cm⁻², and allows providing a high-quality nitride semiconductor multilayer structure. Here, the atoms supplied for the formation of the nuclei diffuse through the surface of the single crystal substrate, and form crystals at stable locations. The nuclei are readily formed particularly in terraces if the diffusion distance of the atoms is sufficiently long. Accordingly, the smaller the off-angle of the single crystal substrate, the longer the terrace width is, and hence the density of the nuclei can be lowered more easily.

The invention of claim 8 is a nitride semiconductor multilayer structure production method, by low-pressure MOVPE under a condition where a single crystal substrate is disposed in a reactor, comprising: step (a) of forming, on one surface of the single crystal substrate, a plurality of island-like nuclei formed of a nitride semiconductor that contains Al as a constituent element, by supplying an A1 raw material gas and a N raw material gas into the reactor under a predefined substrate temperature and a predefined growth pressure and under a condition where a ratio of the amount of substance of the N raw material gas with respect to the amount of substance of the Al raw material gas is set to a first amount of substance ratio; step (b) of forming a first nitride semiconductor layer so as to fill gaps between adjacent nuclei and to cover all the nuclei, by supplying an Al raw material gas and a N raw material gas into the reactor under a predefined substrate temperature and a predefined growth pressure and under a condition where a ratio of the amount of substance of the N raw material gas with respect to the amount of substance of the A1 raw material gas is set to a second amount of substance ratio; and step (c) of forming a second nitride semiconductor layer on the first nitride semiconductor layer, by supplying an Al raw material gas and a N raw material gas into the reactor under a predefined substrate temperature and a predefined growth pressure and under a condition where a ratio of the amount of substance of the N starting gas with respect to the amount of substance of the Al raw material gas is set to a third amount of substance ratio, wherein the first nitride semiconductor layer and the second nitride semiconductor layer contain Al as a constituent element, respectively; and the substrate temperatures in the steps (a) to (c) are set to same, and the growth pressures in the steps (a) to (c) for forming the nuclei, the first nitride semiconductor layer and the second nitride semiconductor layer are set to same. In the present invention, the nuclei and the semiconductor layers can be formed without modification of the substrate temperature or the growth pressure in each of the steps. Therefore, this allows shortening production time and preventing deterioration of the nuclei and the first nitride semiconductor layer caused by the changes in substrate temperature or growth pressure.

The invention of claim 9 is the production method according to claim 8, wherein the first amount of substance ratio in the step (a) is set to a value in a range of 10 to 1000.

The invention of claim 10 is the production method according to claim 8 or 9, wherein the second amount of substance ratio in the step (b) is set to a value in a range of 40 to 60. This invention allows preventing the occurrence of white turbidity caused by excess supply of either of raw material gas.

The invention of claim 11 is the production method according to any one of claims 8 to 10, wherein the third amount of substance ratio in the step (c) is set to a value in a range of 1 to 100. This invention allows forming the second nitride semiconductor layer without worsening of the surface state.

The invention of claim 12 is the production method according to any one of claims 8 to 11, wherein in the step (a), a supply amount of the A1 raw material gas is 0.01 L/min to 0.1 L/min under standard state, and a supply amount of the N raw material gas is 0.01 L/min to 0.1 L/min under standard state.

The invention of claim 13 is the production method according to any one of claims 8 to 12, wherein in the step (b), a supply amount of the Al raw material gas is 0.1 L/min to 1 L/min under standard state, and a supply amount of the N raw material gas is 0.1 L/min to 1 L/min under standard state.

The invention of claim 14 is the production method according to any one of claims 8 to 13, wherein in the step (c), a supply amount of the Al raw material gas is 0.1 L/min to 1 L/min under standard state, and a supply amount of the N raw material gas is 0.01 L/min to 1 L/min under standard state.

The invention of claim 15 is the production method according to any one of claims 8 to 14, wherein the Al raw material gas supplied in each of the steps (a) to (c) is trimethyl aluminum.

The invention of claim 16 is the production method according to any one of claims 8 to 15, wherein the N raw material gas supplied in each of the steps (a) to (c) is NH₃.

The invention of claim 17 is the production method according to any one of claims 8 to 16, wherein a carrier gas supplied in each of the steps (a) to (c) is hydrogen.

The invention of claim 18 is the nitride semiconductor multilayer structure production method according to any one of claims 8 to 17, wherein the substrate temperature is set to between 1300°C and 1500°C. In this invention, during formation of the nuclei, the diffusion length of the constituent elements deposited onto the abovementioned one surface of the single crystal substrate becomes longer compared with a case where the substrate temperature is lower than 1300°C. As a result, this allows reducing the density of the nuclei, allows easily preventing the density of the nuclei from exceeding 6×10⁹ cm⁻², and allows providing a high-quality nitride semiconductor multilayer structure that is formed of a nitride semiconductor containing Al as a constituent element.

The invention of claim 19 is the nitride semiconductor multilayer structure production method according to any one of claims 8 to 18, wherein the Al raw material gas, where Al is a component of the AlN, is supplied continuously into the reactor in each of the steps (a) to (c), and the N raw material gas, where N is a component of the AlN, is supplied intermittently in each of the step (a) and the step (b). This invention allows forming, yet more reliably, the nuclei and the first nitride semiconductor layer the nitride semiconductor layer.

The invention of claim 20 is a nitride semiconductor light-emitting element provided with a nitride semiconductor multilayer structure. The nitride semiconductor multilayer structure comprises a plurality of island-like nuclei that are formed of a nitride semiconductor containing Al as a constituent element, and are formed on one surface of a single crystal substrate; a first nitride semiconductor layer containing Al as a constituent element and formed on the abovementioned one surface side of the single crystal substrate so as to fill gaps between adjacent nuclei and to cover all the nuclei; and a second nitride semiconductor layer containing A1 as a constituent element and formed on the first nitride semiconductor layer. The nitride semiconductor light-emitting element further comprises an n-type nitride semiconductor layer formed on the nitride semiconductor multilayer structure; a light-emitting layer formed on the n-type nitride semiconductor layer; and a p-type nitride semiconductor layer formed on the light-emitting layer. The nitride semiconductor light-emitting element is characterized in that the density of the nuclei is less than 6×10⁹ cm⁻².

By virtue of this invention, a stacked structure of an n-type nitride semiconductor layer, a light-emitting layer and a p-type nitride semiconductor layer can be formed on a high-quality nitride semiconductor multilayer structure having few threading dislocations. As a result, there can be achieved a high-quality nitride semiconductor multilayer structure and light-emitting layer, and there can be reduced the number of non-radiative recombination centers derived from threading dislocations. Emission efficiency can be enhanced as a result.

### EFFECT OF THE INVENTION

According to the invention of claim 1, it can obtain a high-quality nitride semiconductor multilayer structure that is formed of a nitride semiconductor containing Al as a constituent element.

According to the invention of claim 8, it can achieve a method for producing a nitride semiconductor multilayer structure in which it is possible to shorten the production time and to prevent deterioration of the nuclei and the first nitride semiconductor layer caused by changes in substrate temperature or growth pressure.

According to the inventions of claims 8 and 9, it can provide a high-quality nitride semiconductor multilayer structure that are formed of a nitride semiconductor containing Al as a constituent element.

According to the invention of claim 20, it can provide a high-quality nitride semiconductor multilayer structure and a light-emitting layer, and can reduce the number of non-radiative recombination centers derived from threading dislocations. As a result, it can enhance emission efficiency.

### BRIEF DESCRIPTION OF THE DRAWINGS

Fig. 1A is a schematic cross-sectional diagram of a nitride semiconductor light-emitting element according to an embodiment;
Fig. 1B is a schematic cross-sectional diagram of a relevant portion of the nitride semiconductor light-emitting element according to the embodiment;
Fig. 2A is an AFM micrograph of the surface state of a sample in which a plurality of nuclei are formed on one surface of a single crystal substance used for the nitride semiconductor light-emitting element, said plurality of nuclei being formed of a nitride semiconductor containing Al as a constituent element and formed under a condition where a substrate temperature is set to 1300°C;
Fig. 2B is an AFM micrograph of the surface state of a sample in which a plurality of nuclei are formed on one surface of a single crystal substance used for the nitride semiconductor light-emitting element, said plurality of nuclei being formed of a nitride semiconductor containing A1 as a constituent element and formed under a condition where a substrate temperature is set to 1000°C;
Fig. 3 is an X-ray rocking curve diagram of a comparative example and a working example in which a nitride semiconductor multilayer structure is formed on one surface side of a single crystal substrate used in the nitride semiconductor light-emitting element; and
Fig. 4 is an AFM micrograph of the surface of a nitride semiconductor multilayer structure according to the nitride semiconductor light-emitting element.

### MODE FOR CARRYING OUT THE INVENTION

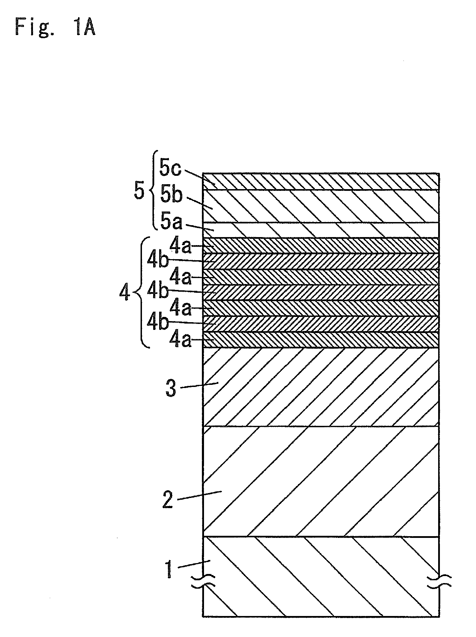

The nitride semiconductor light-emitting element of the present embodiment is an ultraviolet light-emitting diode. In the nitride semiconductor light-emitting element, as illustrated in Fig. 1A, an n-type nitride semiconductor layer **3** is formed on one surface side of a single crystal substrate **1** for epitaxial growth, a buffer layer **2** formed of a nitride semiconductor multilayer structure containing Al as a constituent element lies therebetween; a light-emitting layer **4** is formed on an upper surface side of the n-type nitride semiconductor layer **3**; and a p-type nitride semiconductor layer **5** is formed on an upper surface side of the light-emitting layer **4.** Although not shown in the figure, a cathode electrode is formed on the n-type nitride semiconductor layer **3** and an anode electrode is formed on the p-type nitride semiconductor layer **5.**

A sapphire substrate is used as the single crystal substrate **1.** The single crystal substrate **1** has the abovementioned one surface that exhibits an off-angle of 0.15° with respect to the (0001) plane, i.e. the c-plane.

The buffer layer **2** is provided for the purpose of reducing threading dislocations in the n-type nitride semiconductor layer **3** and reducing residual strain in the n-type nitride semiconductor layer **3.**

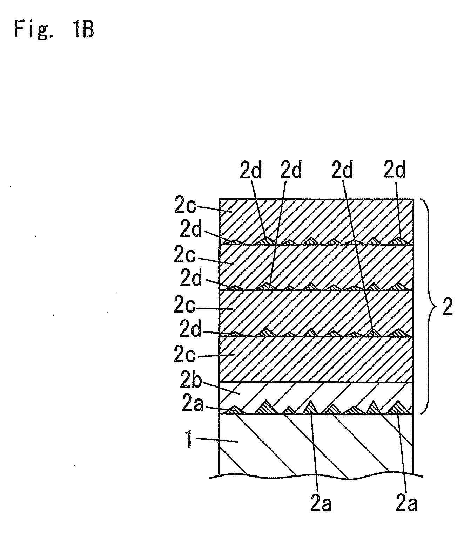

The nitride semiconductor multilayer structure that constitutes the buffer layer **2,** as illustrated in Fig. 1B, comprises: a plurality of island-like nuclei (growth nuclei) **2a;** a first semiconductor layer **2b;** and a second nitride semiconductor layer **2c.** The plurality of island-like nuclei 2a are formed of AlN which is a nitride semiconductor containing Al as a constituent element. The plurality of island-like nuclei **2a** are formed on the abovementioned one surface of the single crystal substrate **1** formed of a sapphire substrate. The first nitride semiconductor layer **2b** is formed of an AlN layer containing Al as a constituent element. The first nitride semiconductor layer **2b** is formed on the abovementioned one surface side of the single crystal substrate **1** so as to fill gaps between the adjacent nuclei **2a** and to cover all the nuclei **2a.** The second nitride semiconductor layer **2c** is formed of an AlN layer containing Al as a constituent element. The second nitride semiconductor layer **2c** is formed on the first nitride semiconductor layer **2b.** In the buffer layer **2**, with a view to increasing the film thickness of the buffer layer **2**, a unit layer is repeatedly formed three times. Here, each of the unit layers comprises a plurality of island-like crystals **2d** and a second nitride semiconductor layer **2c**. The plurality of island-like crystals **2d** are formed of AlN containing Al as a constituent element, and are formed on the second nitride semiconductor layer 2c. The third nitride semiconductor layer 2c is formed of AlN layer containing Al as a constituent element, and is formed so as to fill gaps between the adjacent island-like crystals **2d** and to cover all the island-like crystals **2d**. The island-like crystals **2d** are formed for the purpose of further reducing threading dislocations, by causing threading dislocations to bend, so that loops are formed by adjacent threading dislocations. Herein, threading dislocations are sufficiently reduced through the effect of the nuclei **2a** that are formed on the abovementioned one surface of the single crystal substrate **1**. Therefore, extremely few threading dislocations reach the island-like crystals **2d**. Accordingly, the threading dislocation reducing effect elicited by the island-like crystals **2d** is sufficiently smaller than the threading dislocation reducing effect elicited by the nuclei **2a**, because there are extremely few threading dislocations that are capable of forming loops. In the present embodiment, the height of the nuclei **2a** is set to about 30 nm, the film thickness of the first nitride semiconductor layer **2b** is set to 500 nm, the film thickness of the second nitride semiconductor layer **2c** is set to 1 µm, and the height of the island-like crystals **2d** is set to about 10 nm. Thus, the film thickness of the entire buffer layer **2** amounts to about 4.5 µm. However, these values are merely examples, and are not particularly limited thereto. The film thickness of the entire buffer layer **2** is preferably set to be large, in order to reduce threading dislocations and enhance heat dissipation. However, if the film thickness of the entire buffer layer **2** is excessively large, it is likely to occur cracks due to lattice mismatch between the single crystal substrate **1** and the buffer layer **2**. Preferably, therefore, the film thickness does not exceed 10 µm, from the viewpoint of preventing occurrence of cracks during production. The number of stacked unit layers, each of which is formed of the island-like crystals **2d** and the second nitride semiconductor layer **2c**, is not particularly limited, so long as it is a number that precludes occurrence of cracks. So long as the buffer layer **2** contains Al as a constituent element, the nitride semiconductor of the buffer layer **2** is not limited to AlN, and for instance AlGaN or AlInN may be used. The above-described unit layers need not necessarily be provided, so long as the buffer layer **2** includes at least the plurality of nuclei **2a**, the first nitride semiconductor layer **2c** and the second nitride semiconductor layer **2c**. However, configuration of providing the unit layers is advantageous in terms of reducing the density of the threading dislocations.

As described above, the abovementioned one surface of the single crystal substrate **1** on which the nuclei **2a** and the first nitride semiconductor layer **2b** are formed has an off-angle of 0.15° with respect to the c-plane. That is, the nuclei are formed on the abovementioned one surface of the single crystal substrate 1 having an off-angle, with respect to the c-plane, that ranges from 0° to 0.2°. The atoms which are supplied in order to form the nuclei **2a** diffuse over the surface of the single crystal substrate 1, and form crystals at stable locations. In a case where the diffusion length of the atoms is sufficiently long, the nuclei **2a** can be readily formed particularly in terraces. Accordingly, the smaller the off-angle of the single crystal substrate **1** as in the present embodiment, the longer the terrace width is, and hence the density of the nuclei **2a** can be readily reduced. Therefore, it can provide a high-quality nitride semiconductor multilayer structure. If the off-angle of the single crystal substrate **1** is greater than 0.2°, the terrace width becomes shorter and hence the density of the nuclei **2a** increases, which makes it difficult to obtain a high-quality nitride semiconductor multilayer structure.

To form the buffer layer **2**, the single crystal substrate **1** formed of a sapphire substrate is introduced into the reactor of MOVPE apparatus; thereafter, the substrate temperature is raised to a predefined temperature in a range of 1300°C to 1500°C (for instance, 1300°C), while keeping the pressure in the reactor at a predefined growth pressure (for instance, 10 kPa ≒ 76 Torr), and then the abovementioned one surface of the single crystal substrate **1** is purified through heating for a predefined lapse of time (for instance, 5 minutes); thereafter, under a condition where the substrate temperature is held at a temperature identical to the abovementioned predefined temperature (for instance, 1300°C), the flow rate of trimethyl aluminum(TMA1) which is a raw material of aluminum (group III raw material) is set to 0.02 L/min (20 SCCM) under standard state, and the flow rate of ammonia(NH₃) which is a raw material of nitrogen (group V raw material) is set to 0.02 L/min (20 SCCM) under standard state, NH₃ is caused to flow intermittently (in pulses) into the reactor while TMA1 is flowing into the reactor, to form thereby a plurality of island-like nuclei **2a** formed of AlN and having a first predefined height (for instance, 30 nm). In the formation of the nuclei **2a**, the ratio of the amount of substance of ammonia to trimethyl aluminum supplied into the reactor is 32 in the present embodiment, which is set to in a range from 10 to 1000. In the present invention, the flow rates of trimethyl aluminum and ammonia supplied into the reactor are not limited to 0.02 L/min under standard state, and may be appropriately set in the range of 0.01 L/min to 0.1 L/min under standard state. Note that NH₃ and TMA1 that are ordinary used as raw materials to grow AlN possibly form microparticles during the transport process to the single crystal substrate **1** due to the reaction (parasitic reaction). If these raw materials are continuously supplied, the parasitic reactions occur readily, and microparticles are formed in significant numbers. Some of these microparticles are supplied onto the single crystal substrate **1**, whereby they hamper the growth of AlN. Therefore, NH₃ is supplied intermittently, in order to suppress the parasitic reactions. Herein, H₂ gas is used as a carrier gas for transporting both TMA1 and NH₃.

To form the first nitride semiconductor layer **2b** after the above-described formation of nuclei **2a**, the substrate temperature is held at the abovementioned predefined temperature (i.e. 1300°C) while keeping the pressure in the reactor at the abovementioned predefined growth pressure (i.e. 10 kPa ≒ 76 Torr), the flow rate of TMA1 is set to 0.29 L/min (290 SCCM) and the flow rate of NH₃ is set to 0.4 L/min (400 SCCM), and then NH₃ is caused to flow intermittently into the reactor while TMA1 is flowing into the reactor in the same way as during the formation of the nuclei **2a**, thereby growing the first nitride semiconductor layer **2b** formed of an AlN layer and having a first predefined film thickness (for instance, 500 nm). In the formation of the first nitride semiconductor layer **2b**, the ratio of the amount of substance of ammonia to trimethyl aluminum supplied into the reactor is 50 in the present embodiment, which is set to in a range from 40 to 60. Since the ratio of the amount of substance of ammonia and trimethyl aluminum supplied into the reactor is thus set in the range of 40 to 60, it allows preventing the occurrence of white turbidity that is caused by excess supply of either of the raw material gas. In the present invention, the flow rates of trimethyl aluminum and ammonia supplied into the reactor are not limited to the abovementioned values, and may be appropriately set in a range of 0.1 L/min to 1 L/min under standard state. As is the case during the formation of the nuclei **2a**, for instance H₂ gas may be used as a carrier gas for both TMA1 and NH₃.

To form the second nitride semiconductor layer **2c**, the substrate temperature is held at the abovementioned predefined temperature (i.e. 1300°C) while keeping the pressure in the reactor at the abovementioned predefined growth pressure (i.e. 10 kPa ≒ 76 Torr), the flow rate of TMA1 is set to 0.29 L/min (290 SCCM) and the flow rate of NH₃ is set to 0.02 L/min (20 SCCM), and then TMA1 and NH₃ are caused to flow continuously and simultaneously, thereby forming the second nitride semiconductor layer **2c** formed of an AlN layer and having a second predefined film thickness (for instance, 1 µm). In the formation of the second nitride semiconductor layer **2c**, the ratio of the amount of substance of ammonia to trimethyl aluminum supplied into the reactor is 2.5 in the present embodiment, which is set to in a range from 1 to 100. Since the ratio of the amount of substance of ammonia and trimethyl aluminum supplied into the reactor is thus set in the range of 1 to 100, it allows forming the second nitride semiconductor layer 2c without worsening of the surface state. In the present invention, the flow rates of trimethyl aluminum and ammonia supplied into the reactor are not limited to the abovementioned values, and may be appropriately set in a range of 0.1 L/min to 1 L/min and 0.01 L/min to 1 L/min under standard state, respectively. Herein, it is preferred to flow NH₃ intermittently in order to inhibit the parasitic reactions; however in this case, there are then lapses of time in which no NH₃ is supplied, and hence the growth rate may be lower than in continuous supply. In the present embodiment, the second nitride semiconductor layers **2c** need to be layered thickly to a total thickness of 4 µm (1 µm × 4 layers). Accordingly, the second nitride semiconductor layer **2c** is formed in accordance with a method that involves continuous and simultaneous flow of TMA1 and NH₃, in order to increase the growth rate. Herein, for instance H₂ gas may be used as a carrier gas for both TMAl and NH₃.

To form the island-like crystals **2d**, the substrate temperature is held at the abovementioned predefined temperature (for instance, 1300°C), the flow rate of TMA1 is set to 0.29 L/min (290 SCCM) and the flow rate of NH₃ is set to 0.02 L/min (20 SCCM), and then NH₃ is caused to flow intermittently into the reactor while TMA1 is flowing into the reactor, thereby forming the plurality of island-like crystals **2d** formed of AlN and having a second predefined height (for instance, 10 nm). In the formation of the island-like crystals **2d**, the ratio of the amount of substance of ammonia to trimethyl aluminum supplied into the reactor is 2.5 in the present embodiment, which is set to in a range from 1 to 50. Since the ratio of the amount of substance of ammonia and trimethyl aluminum supplied into the reactor is thus set in the range of 1 to 50, it allows forming the island-like crystals **2d** without worsening of the surface state. In the present invention, the flow rates of trimethyl aluminum and ammonia supplied into the reactor are not limited to the abovementioned values, and may be appropriately set in the range of 0.1 L/min to 1 L/min under standard state. Herein, for instance H₂ gas may be used as a carrier gas for both TMAl and NH₃.

Then, the process of forming the second nitride semiconductor layer **2c** and the process of forming the island-like crystals **2d** are repeated, thereby the buffer layer 2 is formed so that the total film thickness thereof takes on a third predefined film thickness (for instance 4.5 µm). Note that the outermost layer of the buffer layer **2** is the second nitride semiconductor layer **2c**.

As is clear in the above explanation, in the formation of the buffer layer **2**, the nitride semiconductor multilayer structure that has the plurality of nuclei **2a**; the first nitride semiconductor layer **2b**; the second nitride semiconductor layer **2c**; and the plurality of island-like crystals **2d**, is formed through appropriate combinations of a plurality of growth conditions. Besides, the substrate temperatures are set to same as well as the growth pressures are set to same during the growth of the nuclei **2a**, the first nitride semiconductor layer **2b** and the second nitride semiconductor layer **2c**. In the present embodiment, therefore, the nuclei **2a** and the nitride semiconductor layers **2b**, **2c** can be formed without modification of the substrate temperature and the growth pressure. Therefore, this allows shortening production time and preventing deterioration of the nuclei **2a** and the first nitride semiconductor layer **2b** caused by the changes in substrate temperature or growth pressure.

In the present embodiment, the substrate temperature is set in the range of 1300°C to 1500°C. Therefore, the diffusion length of the constituent elements deposited onto the abovementioned one surface of the single crystal substrate **1** can be made longer compared with a case where the substrate temperature is lower than 1300°C. Hence, it becomes possible to easily reduce the density of the nuclei **2a** to a density less than 6×10⁹ nuclei cm⁻². Noted that if the substrate temperature exceeds 1500°C, the hydrogen gas in the carrier gas elicits readily to cause a reduction action to the abovementioned one surface of the single crystal substrate **1**, which is a sapphire substrate. This renders the abovementioned one surface of the sapphire substrate prone to undergoing changes in the crystalline state, and as a result the nuclei **2a** are formed less readily. Besides, in a case where the substrate temperature exceeds 1500°C, the low-pressure MOPVE apparatus is required a highly heat-resistance, which entails dramatically higher costs in terms of the need for construction modifications and the use of heat-resistant members. Therefore, in the present invention, it is not suitable for formation of nuclei **2a** in a condition where the substrate temperature exceeds 1500°C.

As explained above, the present embodiment utilizes such a growth method that involves intermittent flow of NH₃ under continued supply of TMA1 into a reactor for the formations of the nuclei **2a**, the first nitride semiconductor layer **2b** and the island-like crystals **2d**. However, the growth method is not limited thereto, and for instance such a growth method can be adopted in which it flows TMA1 and NH₃ simultaneously (simultaneous supply method), or in which it flows TMA1 and NH₃ alternately (alternate supply method).

The n-type nitride semiconductor layer **3**, the purpose of which is to inject electrons into the light-emitting layer **4**, is formed of a Si-doped n-type Al_{0.55} Ga_{0.45}N layer formed on the buffer layer **2**. The film thickness of the n-type nitride semiconductor layer **3** is set to 2 µm, but the thickness is not particularly limited thereto. Besides, the n-type nitride semiconductor layer **3** is not limited to a single-layer structure, and may have a multilayer structure. For instance, the n-type nitride semiconductor layer 3 may be formed of a Si-doped n-type Al_{0.7}Ga_{0.3}N layer on the first buffer layer **2**, and a Si-doped n-type Al_{0.55}Ga_{0.45}N layer on the n-type Al_{0.7}Ga_{0.3}N layer.

The growth conditions of the n-type nitride semiconductor layer **3** include setting the growth temperature to 1200°C; setting the growth pressure to a predefined pressure (for instance, 10 kPa); using TMA1 as an aluminum raw material, trimethyl gallium (TMGa) as a gallium raw material, NH₃ as a nitrogen raw material, and tetraethyl silane (TESi) as a raw material of silicon, where silane being an impurity that imparts n-type conductivity; and using H₂ gas as the carrier gas for transport of the raw materials. The flow rate of TESi is set to 0.0009 L/min (0.9 SCCM) under standard state.
Herein, the above raw materials are not particularly limited. For instance, triethyl gallium (TEGa) may be used as the gallium raw material, a hydrazine derivative may be used as the nitrogen raw material, and monosilane (SiH₄) may be used as the silicon raw material.

The light-emitting layer **4** has a quantum well structure in which a barrier layer **4a** and a well layer **4b** are alternately stacked so that the stack has three well layers **4b.** In the light-emitting layer **4,** each barrier layer **4a** is formed of Al_{0.55}Ga_{0.45}N layer having 8 nm-film thickness and each well layer **4b** is formed of Al_{0.4}Ga_{0.60}N layer having 2 nm-film thickness. The respective compositions of the barrier layer **4a** and the well layer **4b** are not limited, and may be appropriately set in accordance with the desired emission wavelength. The number of well layers **4b** in the light-emitting layer **4** is not particularly limited to three. Also, the light-emitting layer **4** is not limited to having a multiple quantum well structure in which the well layer **4b** is provided in plurality, and may have a single quantum well structure provided with one well layer **4b**. The film thickness of each barrier layer **4a** and well layer **4b** is not particularly limited. The combination of materials in the well layer or the barrier layer is not limited to the abovementioned one. The combination of materials is preferred to include Al among the constituent elements and has band-gap energy greater than that of GaN. Accordingly, AlGaInN or AlInN can also be used with appropriately adjusted the compositions. Specific examples of combinations of well layer/barrier layer include, for instance, AlGaN/AlGaInN, AlGaN/AlInN, AlGaNInN/AlGaInN, AlGaInN/AlGaN, AlGaInN/AlInN, AlInN/AlInN, AlInN/AlGaN and AlInN/AlGaInN. Noted that, in order to bring out the functionality of the quantum well, the band-gap energy of the barrier layer must be greater than that of the well layer.

The growth conditions of the light-emitting layer **4** include setting the growth temperature to 1200°C, which is identical to that for the n-type nitride semiconductor layer **3**; setting the growth pressure to the abovementioned predefined growth pressure (for instance 10 kPa); using TMAl as an aluminum raw material, TMGa as a gallium raw material, and NH₃ as a nitrogen raw material. The growth conditions of the barrier layer **4a** are set to be identical to the growth conditions of the n-type nitride semiconductor layer **3**, except that herein no TESi is supplied. As to the growth conditions of the well layer **4b**, the molar ratio of TMA1 to the group III raw materials ([TMA1]/{[TMA1]+[TMGa]}) is set to be smaller than that for the growth conditions of the barrier layer **4a**, with a view to obtaining a desired composition. In the present embodiment, the barrier layer **4a** is not doped with impurities, but the embodiment is not limited thereto. The barrier layer **4a** may be doped with an n-type impurity, such as silicon, to an impurity concentration that does not impair crystal quality of the barrier layer **4a**.

The p-type nitride semiconductor layer **5** is formed of a first p-type nitride semiconductor layer **5a**; a second p-type nitride semiconductor layer **5b**; and a third p-type nitride semiconductor layer **5c**. The first p-type nitride semiconductor layer **5a** is formed of a Mg-doped p-type AlGaN layer, and formed on the light-emitting layer **4**. The second p-type nitride semiconductor layer **5b** is formed of a Mg-doped p-type AlGaN layer, and formed on the first p-type nitride semiconductor layer **5a**. The third p-type nitride semiconductor layer **5c** is formed of a Mg-doped p-type GaN layer, and formed on the second p-type nitride semiconductor layer **5b**. The composition of the first p-type nitride semiconductor layer **5a** and the second p-type nitride semiconductor layer **5b** are set in such a manner that the band-gap energy of the first p-type nitride semiconductor layer **5a** is greater than the band-gap energy of the second p-type nitride semiconductor layer **5b**. The composition of the second p-type nitride semiconductor layer **5b** is set in such a manner that the band-gap energy thereof is identical to that of the barrier layer **4a** of the light-emitting layer **4**. In the present embodiment, the p-type nitride semiconductor layer **5** is set so that the film thickness of the first p-type nitride semiconductor layer **5a** is 15 nm, the film thickness of the second p-type nitride semiconductor layer **5b** is 50 nm, and the film thickness of the third p-type nitride semiconductor layer **5c** is 15 nm. However, the p-type nitride semiconductor layer **5** is not particularly limited to such film thicknesses. The nitride semiconductor used in the p-type nitride semiconductor layer **5** is not particularly limited to above ones, and for instance AlGaInN may be used. Further, not only AlGaInN but also InGaN may be used in the third p-type nitride semiconductor layer **5c**.

Herein, each of the growth conditions of the first p-type nitride semiconductor layer **5a** and the second p-type nitride semiconductor layer **5b** of the p-type nitride semiconductor layer **5** include setting the growth temperature to 1050°C; setting the growth pressure to the abovementioned predefined growth pressure (herein, 10 kPa); using TMA1 as an aluminum raw material, TMGa as a gallium raw material, NH₃ as a nitrogen raw material, and biscyclopentadienyl magnesium (Cp₂Mg) as a raw material of magnesium, where magnesium being an impurity that imparts p-type conductivity; and using H₂ gas as the carrier gas for transport of the raw materials. The growth conditions of the third p-type nitride semiconductor layer **5c** are basically identical to the growth conditions of the second p-type nitride semiconductor layer **5b**, but differ in that herein TMAl is not supplied. During growth of all the first to third p-type nitride semiconductor layers **5a** to **5c**, the flow rate of Cp₂Mg is set to 0.02 L/min (20 SCCM) under standard state, and the molar ratio (flow rate ratio) between the group III raw materials is appropriately adjusted in accordance with the respective compositions of the first to third p-type nitride semiconductor layers **5a** to **5c**.

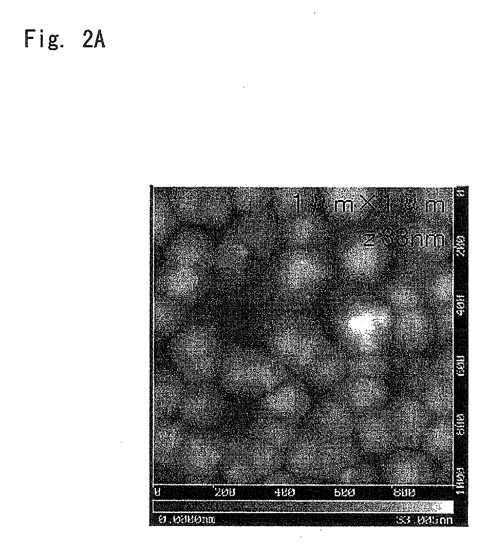

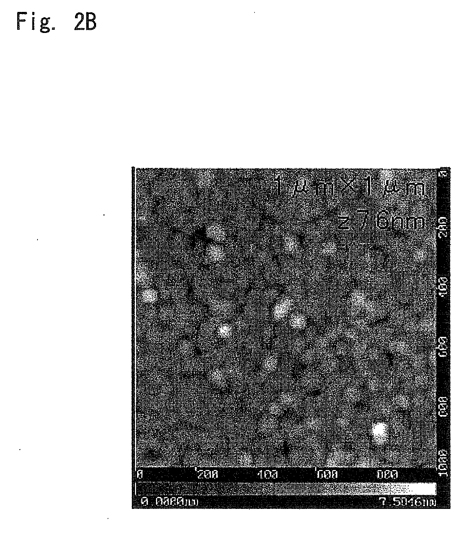

The surface states of various samples, in which the plurality of nuclei **2a** of AlN are formed on the abovementioned one surface (c-plane) of the single crystal substrate **1** of a sapphire substrate in dissimilar substrate temperatures one another, were observed using an atomic force microscope (AFM), in order to check the influence of the formation temperature (growth temperature) of the nuclei **2a** in the nitride semiconductor multilayer structure, which constitutes the buffer layer **2**, on the density of the nuclei **2a** formed on the abovementioned one surface of the single crystal substrate **1**. As an example, Fig. 2A illustrates an AFM micrograph of a sample in which the plurality of nuclei **2a** are formed on the abovementioned one surface of the single crystal substrate **1** under the condition where the substrate temperature is set to 1300°C, and Fig. 2B illustrates an AFM micrograph of a sample in which the plurality of nuclei **2a** are formed on the abovementioned one surface of the single crystal substrate 1 under the condition where the substrate temperature is set to 1300°C. Fig. 2A and Fig. 2B reveal that the island-like nuclei **2a** are formed on the abovementioned one surface of the single crystal substrate **1** for both substrate temperatures, 1300°C and 1000°C. In both cases, it is found that most of the surfaces of each the nuclei **2a** are formed by such faces that are tilted with respect to the c-plane, which is the growth plane. It is also found that the density of the nuclei **2a** formed under the substrate temperature of 1000°C as in the case of Fig. 2B is 3×10¹⁰ nuclei cm⁻², whereas the density of the nuclei **2a** formed under the substrate temperature of 1300°C as in the case of Fig. 2A is 6×10⁹ nuclei cm⁻², i.e. the density of the nuclei **2a** in the latter case is about one fifth of that in the former case, and the bonding interface between adjacent nuclei **2a** in the latter case is smaller.

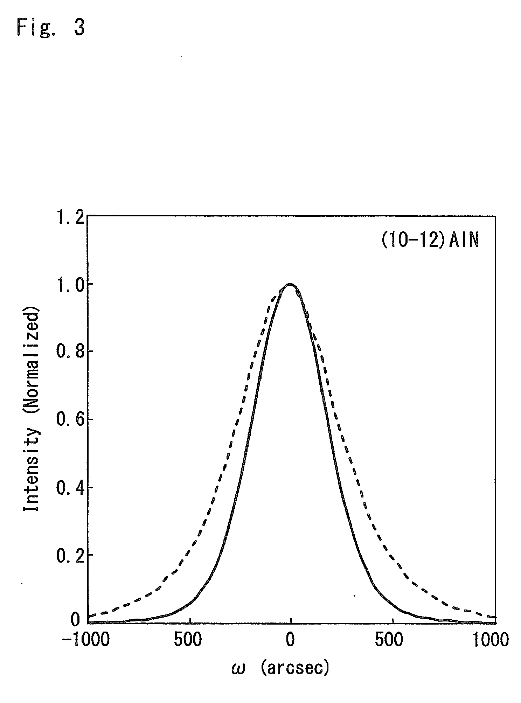

For the nitride semiconductor multilayer structure that constitutes the buffer layer **2**, there was produced next a working example and a comparative example. For producing the working example, the formation temperature of the nuclei **2a** of AlN was set to 1300°C (i.e. density of the nuclei **2a** was set to 6×10⁹ nuclei cm⁻²); the first nitride semiconductor layer **2b**, the second nitride semiconductor layer **2c** and the island-like crystals **2d** were all formed of AlN, and heights, film thicknesses and so forth thereof were set to the above-described numerical value examples in the embodiment. For producing the comparative example, the formation temperature of the nuclei **2a** of AlN was set to 1000°C (i.e. density of the nuclei **2a** was set to 3×10¹⁰ nuclei cm⁻²); the first nitride semiconductor layer **2b**, the second nitride semiconductor layer **2c** and the island-like crystals **2d** were all formed of AlN, and heights, film thicknesses and so forth thereof were set to the above-described numerical value examples in the embodiment. Fig. 3 illustrates X-Ray Rocking Curves (XRC) for the nitride semiconductor multilayer structures of the working example and the comparative example, obtained by ω scan of an X-ray diffraction for the AlN (10-12) plane (which is an index denoting the degree of fluctuation to the c-axis direction of the crystal), which reflects the density of mixed dislocations and edge dislocations.

Fig. 3 indicates that the half width of the XRC of the nitride semiconductor multilayer structure of the comparative example (dotted line), where the density of the nuclei 2a is 3×10¹⁰ nuclei cm⁻², is of 600 arcsec, whereas the half width of the XRC of the nitride semiconductor multilayer structure of the working example (solid line), in which the density of the nuclei **2a** is 6×10⁹ nuclei cm⁻², is of 440 arcsec. The XRC half width, thus, is further reduced in the working example than in the comparative example. This indicates that the working example is a high-quality nitride semiconductor multilayer structure in which the density of mixed dislocations and edge dislocations is further reduced and the density of threading dislocations is likewise reduced compared with the comparative example.

It was verified that the density of threading dislocations decreased as the decrease of the density of the nuclei **2a** by, for instance, cross-sectional TEM (transmission electron microscope) among others. On the other hand, the smaller the density of the nuclei **2a**, the greater becomes the spacing between the adjacent nuclei **2a** thereby the greater becomes the film thickness of the first nitride semiconductor layer **2b** that fills gaps between the adjacent nuclei **2a** and that covers all the nuclei **2a**. If the film thickness of the first nitride semiconductor layer **2b** is excessively large, cracks may occur on account of lattice mismatch between the single crystal substrate and the first nitride semiconductor layer **2b**. As is known, epitaxial lateral overgrowth (ELO), which is a crystal growth technique that combines a lateral growth and a selective wavelength that uses a selective wavelength mask, requires a growth thickness that is comparable to the spacing between adjacent selective wavelength masks, in order to grow a nitride semiconductor layer (GaN layer) that has a planar surface formed through mutual bonding of adjacent growth films. While, in a case where the first nitride semiconductor layer **2b** that contains Al as a constituent element is grown on one surface side of the single crystal substrate by heteroepitaxial growth, cracks are likely to occur on account of lattice mismatch between the single crystal substrate **1** and the first nitride semiconductor layer **2b** if the film thickness of the first nitride semiconductor layer **2b** exceeds 10 µm. Therefore, the spacing between the adjacent nuclei **2a** is preferably less than 10 µm, from the viewpoint of preventing the occurrence of cracks during production. Herein, when the spacing between adjacent nuclei **2a** is 10 µm, the density of the nuclei **2a** amounts to 1×10⁶ nuclei cm⁻². Accordingly, the density of the nuclei **2a**. is preferably set to be equal to or more than 1×10⁶ nuclei cm⁻². The density of the nuclei **2a** is further preferably set to be equal to or more than 1×10⁸ nuclei cm⁻² so that the spacing between nuclei **2a** is less than 1 µm.

Conceivable parameters that control the density of the nuclei **2a** include, for instance, the V/III ratio (molar ratio of group V raw material to group III raw material), the supply amount of group III raw material, and so forth.
However, in order to elicit diffusion of atoms, kinetic energy must be imparted by virtue of the substrate temperature (substrate heat). If the kinetic energy is small, the diffusion distance of the atoms remains short. Therefore, no matter the way in which other parameters than the substrate temperature may be changed, the density of the diffusing nuclei **2a** cannot be controlled in a high density state. Hence, the substrate temperature is deemed to be the most fundamental parameter and the one that exerts the strongest influence on control of nuclei density.

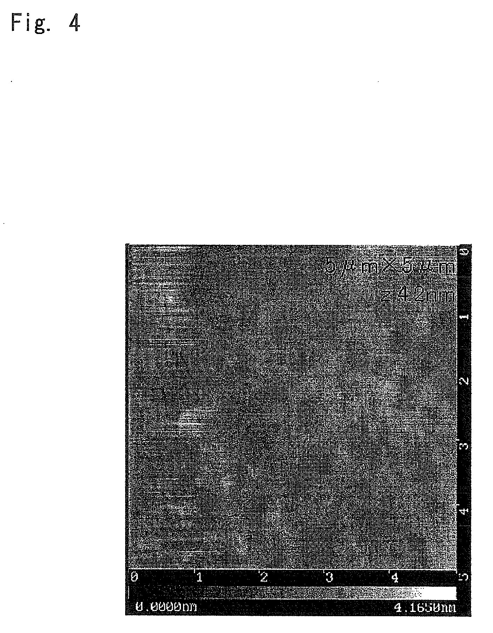

Fig. 4 illustrates an AFM micrograph obtained by AFM observation of the surface state of a nitride semiconductor multilayer structure of the above-described working example. Fig. 4 reveals that irregular structures, which might be derived from the plurality of island-like nuclei **2a**, are not observed on the surface of the nitride semiconductor multilayer structure, and that a film which is planar at the atomic level can be obtained.

The nitride semiconductor multilayer structure of the present embodiment as described above comprises: the plurality of island-like nuclei **2a** that are formed of a nitride semiconductor containing Al as a constituent element, and are formed on the abovementioned one surface of the single crystal substrate **1**; the first nitride semiconductor layer **2b** containing Al as a constituent element and formed on the abovementioned one surface side of the single crystal substrate **1** so as to fill gaps between adjacent nuclei **2a** and to cover all the nuclei **2a**; and the second nitride semiconductor layer **2c** containing Al as a constituent element and formed on the first nitride semiconductor layer **2b**, wherein the density of the nuclei **2a** is less than 6×10⁹ nuclei cm⁻². As a result there can be obtained a high-quality nitride semiconductor multilayer structure that is formed of a nitride semiconductor containing Al as a constituent element. Note that the size of the plurality of island-like nuclei **2a** that are formed on the abovementioned one surface of the single crystal substrate **1** becomes greater as the progress of the growth of the nuclei **2a**. When adjacent nuclei **2a** are bonded to one another, it may cause to generate threading dislocations at the bonding interfaces. However, herein, the bonding interfaces can be reduced because the density of the nuclei **2a** is less than 6×10⁹ nuclei cm⁻². As a result, this allows reducing the threading dislocations that occur upon bonding of adjacent nuclei **2a** to one another. Thus, this allows obtaining a high-quality nitride semiconductor multilayer structure having few threading dislocations.

In the nitride semiconductor multilayer structure of the present embodiment, most of the surfaces of each of the nuclei **2a** are formed by faces that are tilted with respect to the c-plane, which is the growth plane. Therefore, growth in the normal direction (perpendicular direction) to the abovementioned one surface of the single crystal substrate **1** can be suppressed, and growth in the lateral direction along the abovementioned one surface is readily progressed, during formation of the first nitride semiconductor layer **2b.** Thus, threading dislocations, which are likely to track along the growth direction, are less likely to extend in the normal direction of the abovementioned one surface of the single crystal substrate **1** and are likely to bend in a direction parallel to the abovementioned one surface, as similar in the direction of the growth of the first nitride semiconductor layer **2b**. Therefore, threading dislocations are eliminated readily through formation of loops with nearby threading dislocations. As a result, it becomes possible to reduce the density of threading dislocations at the surface of the second nitride semiconductor layer **2c**, and to reduce the density of threading dislocations at the surface of the nitride semiconductor multilayer structure.

In the nitride semiconductor multilayer structure of the present embodiment, by using AlN as the nitride semiconductor that constitutes the nuclei **2a**, it can reduce the number of kinds of constituent elements in the nitride semiconductor that yields the nuclei **2a**. Formation of the nuclei **2a** can be controlled more easily as a result. Herein, AlN is a material having large band-gap energy, namely 6.2 eV. Therefore, in a case where a light-emitting layer **4** which emits ultraviolet light having a wavelength ranging from 250 to 300 nm is formed on the upper surface side of the second nitride semiconductor layer **2c** to produce a nitride semiconductor light-emitting element (ultraviolet light-emitting diode), it becomes possible to prevent the nuclei **2a** from absorbing ultraviolet light that is irradiated by the light-emitting layer **4**, and to enhance the external quantum efficiency of the nitride semiconductor light-emitting element. While, for instance, GaN cannot be used for, because it absorbs ultraviolet light in the abovementioned wavelength region and causes the external quantum efficiency to drop.

In the production method of the nitride semiconductor multilayer structure of the present embodiment, the nuclei **2a** are formed by low-pressure MOVPE on the abovementioned one surface of the single crystal substrate 1, through growing of the nuclei **2a** under substrate temperature conditions such that the density of the nuclei 2a does not exceed 6×10⁹ nuclei cm⁻². Therefore, this allows controlling the density of the nuclei **2a** on the basis of substrate temperature condition, and allows providing a high-quality nitride semiconductor multilayer structure that is formed of a nitride semiconductor containing Al as a constituent element. In the production method of the nitride semiconductor multilayer structure of the present embodiment, the nuclei **2a** formed of AlN are formed by low-pressure MOVPE on the abovementioned one surface of the single crystal substrate **1**, through growing of the nuclei **2a** under substrate temperature conditions such that the density of the nuclei **2a** does not exceed 6×10⁹ nuclei cm⁻², wherein the substrate temperature is set to be 1300°C or higher. Therefore, during formation of the nuclei **2a**, the diffusion length of the constituent elements that are deposited onto the abovementioned one surface of the single crystal substrate **1** becomes longer than a case in which the substrate temperature is lower than 1300°C. As a result, this allows reducing the density of the nuclei **2a**, allows easily achieving a density of the nuclei **2a** less than 6×10⁹ nuclei cm⁻², and allows providing a high-quality nitride semiconductor multilayer structure that is formed of a nitride semiconductor containing Al as a constituent element.

The nitride semiconductor light-emitting element of the present embodiment is provided with the buffer layer **2** formed of the above-described nitride semiconductor multilayer structure; the n-type nitride semiconductor layer **3** formed on the buffer layer **2**; the light-emitting layer **4** formed on the n-type nitride semiconductor layer **3**; and the p-type nitride semiconductor layer **5** formed on the light-emitting layer **4**. Therefore, a stacked structure of the n-type nitride semiconductor layer **3**, the light-emitting layer **4** and the p-type nitride semiconductor layer **5** is formed on the buffer layer **2** formed of a high-quality nitride semiconductor multilayer structure having few threading dislocations. As a result, it can provide high-quality buffer layer **2** and light-emitting layer **4**, and there can be reduced the number of non-radiative recombination centers derived from threading dislocations. Emission efficiency can be enhanced as a result.

In the abovementioned embodiment, low-pressure MOVPE has been exemplified as the production method of the nitride semiconductor multilayer structure, and of the nitride semiconductor light-emitting element provided with the buffer layer **2** having the nitride semiconductor multilayer structure. However, the method is not limited thereto, and other methods can be used, for instance halide vapor phase epitaxy (HVPE), molecular beam epitaxy (MBE) or the like.

In the abovementioned embodiment, a sapphire substrate is used as the single crystal substrate **1**, but the single crystal substrate **1** is not limited to a sapphire substrate, and there may be used, for instance, a spinel substrate, a silicon substrate, a silicon carbide substrate, a zinc oxide substrate, a gallium phosphide substrate, a gallium arsenide substrate, a magnesium oxide substrate, a zirconium boride substrate, or a group III nitride-based semiconductor crystal substrate. Provided that the basic features explained in the abovementioned embodiment are applicable, the technical idea of the present invention can be applied to, and developed into, various structures.

In the nitride semiconductor light-emitting element of the abovementioned embodiment, the emission wavelength of the light-emitting layer **4** is set in the range of 250 nm to 300 nm. Therefore, it can realize a light-emitting diode having the emission wavelength of the ultraviolet region. Accordingly, the nitride semiconductor light-emitting element can be used as an alternative light source of deep ultraviolet light sources, such as mercury lamps and excimer lamps.

## Claims

1. A nitride semiconductor multilayer structure, comprising:
a plurality of island-like nuclei that are formed of a nitride semiconductor containing Al as a constituent element, and are formed on one surface of a single crystal substrate;
a first nitride semiconductor layer containing Al as a constituent element and formed on said one surface side of the single crystal substrate so as to fill gaps between adjacent nuclei and to cover all the nuclei; and
a second nitride semiconductor layer containing Al as a constituent element and formed on the first nitride semiconductor layer,
wherein the density of the nuclei is less than 6×10⁹ nuclei cm⁻².

2. The nitride semiconductor multilayer structure according to claim 1, wherein the density of the nuclei is equal to or more than 1×10⁶ nuclei cm⁻².

3. The nitride semiconductor multilayer structure according to claim 2, wherein the density of the nuclei is equal to or more than 1×10⁸ nuclei cm⁻².

4. The nitride semiconductor multilayer structure according to any one of claims 1 to 3, wherein the nuclei have faces that are tilted with respect to said one surface of the single crystal substrate.

5. The nitride semiconductor multilayer structure according to any one of claims 1 to 4, wherein the nitride semiconductor that constitutes the nuclei is AlN.

6. The nitride semiconductor multilayer structure according to claim 5, wherein the first nitride semiconductor layer and the second nitride semiconductor layer are formed of AlN.

7. The nitride semiconductor multilayer structure according to any one of claims 1 to 6, wherein the single crystal substrate is a sapphire substrate, and said one surface has an off-angle, with respect to the c-plane, ranging from 0° to 0.2°.

8. Method for producing a nitride semiconductor multilayer structure, by low-pressure MOVPE under a condition where a single crystal substrate is disposed in a reactor, comprising:
step (a) of forming, on one surface of the single crystal substrate, a plurality of island-like nuclei formed of a nitride semiconductor that contains Al as a constituent element, by supplying an Al raw material gas and a N raw material gas into the reactor under a predefined substrate temperature and a predefined growth pressure and under a condition where a ratio of the amount of substance of the N raw material gas with respect to the amount of substance of the Al raw material gas is set to a first amount of substance ratio;
step (b) of forming a first nitride semiconductor layer so as to fill gaps between adjacent nuclei and to cover all the nuclei, by supplying an Al raw material gas and a N raw material gas into the reactor under a predefined substrate temperature and a predefined growth pressure and under a condition where a ratio of the amount of substance of the N raw material gas with respect to the amount of substance of the A1 raw material gas is set to a second amount of substance ratio; and
step (c) of forming a second nitride semiconductor layer on the first nitride semiconductor layer, by supplying an A1 raw material gas and a N raw material gas into the reactor under a predefined substrate temperature and a predefined growth pressure and under a condition where a ratio of the amount of substance of the N raw material gas with respect to the amount of substance of the Al raw material gas is set to a third amount of substance ratio,
wherein
the first nitride semiconductor layer and the second nitride semiconductor layer contain A1 as a constituent element, respectively, and
the substrate temperatures in the steps (a) to (c) are set to same, and the growth pressures in the steps (a) to (c) for forming the nuclei, the first nitride semiconductor layer and the second nitride semiconductor layer are set to same.

9. The method for producing a nitride semiconductor multilayer structure according to claim 8, wherein the first amount of substance ratio in the step (a) is set to 10 to 1000.

10. The method for producing a nitride semiconductor multilayer structure according to claim 8 or 9, wherein the second amount of substance ratio in the step (b) is set to 40 to 60.

11. The method for producing a nitride semiconductor multilayer structure according to any one of claims 8 to 10, wherein the third amount of substance ratio in the step (c) is set to 1 to 100.

12. The method for producing a nitride semiconductor multilayer structure according to any one of claims 8 to 11, wherein in the step (a), a supply amount of the A1 raw material gas is in the range of 0.01 L/min to 0.1 L/min under standard state, and a supply amount of the N raw material gas is in the range of 0.01 L/min to 0.1 L/min under standard state.

13. The method for producing a nitride semiconductor multilayer structure according to any one of claims 8 to 12, wherein in the step (b), a supply amount of the Al raw material gas is in the range of 0.1 L/min to 1 L/min under standard state, and a supply amount of the N raw material gas is in the range of 0.1 L/min to 1 L/min under standard state.

14. The method for producing a nitride semiconductor multilayer structure according to any one of claims 8 to 13, wherein in the step (c), a supply amount of the Al raw material gas is in the range of 0.1 L/min to 1 L/min under standard state, and a supply amount of the N raw material gas is in the range of 0.01 L/min to 1 L/min under standard state.

15. The method for producing a nitride semiconductor multilayer structure according to any one of claims 8 to 14, wherein the Al raw material gas supplied in each of the steps (a) to (c) is trimethyl aluminum.

16. The method for producing a nitride semiconductor multilayer structure according to any one of claims 8 to 15, wherein the N raw material gas supplied in each of the steps (a) to (c) is NH₃.

17. The method for producing a nitride semiconductor multilayer structure according to any one of claims 8 to 16, wherein a carrier gas supplied in each of the steps (a) to (c) is hydrogen.

18. The method for producing a nitride semiconductor multilayer structure according to any one of claims 8 to 17, wherein the substrate temperature is set to between 1300°C and 1500°C.

19. The method for producing a nitride semiconductor multilayer structure according to any one of claims 8 to 18,
wherein
the Al raw material gas, where Al is a component of the AlN, is supplied continuously into the reactor in each of the steps (a) to (c), and
the N raw material gas, where N is a component of the AlN, is supplied intermittently in each of the step (a) and the step (b).

20. A nitride semiconductor light-emitting element having the configuration below:
a nitride semiconductor multilayer structure that comprises: a plurality of island-like nuclei that are formed of a nitride semiconductor containing Al as a constituent element, and are formed on one surface of a single crystal substrate; a first nitride semiconductor layer containing Al as a constituent element and formed on said one surface side of the single crystal substrate so as to fill gaps between adjacent nuclei and to cover all the nuclei; and a second nitride semiconductor layer containing Al as a constituent element and formed on the first nitride semiconductor layer;
an n-type nitride semiconductor layer formed on the nitride semiconductor multilayer structure;
a light-emitting layer formed on the n-type nitride semiconductor layer; and
a p-type nitride semiconductor layer formed on the light-emitting layer,
wherein the density of the nuclei is less than 6×10⁹ nuclei cm⁻².
